# EUROPÄISCHE PATENTANMELDUNG

(11) **EP 0 756 375 A2**
(43) Veröffentlichungstag der Anmeldung: **29.01.1997**
(21) Anmeldenummer: 96110516.0
(22) Anmeldetag: 28.06.1996
(51) Int. Cl.: H03G 3/00, H03G 1/00

(54) **Lautstärkenregler für ein Audiogerät**

(30) Priorität: 26.07.1995 DE 19527338
(71) Anmelder: SGS-THOMSON MICROELECTRONICS GMBH, 85630 Grasbrunn (DE)
(72) Erfinder: Kirchlechner, Peter, 84098 Hohenthann (DE)
(74) Vertreter: Klunker . Schmitt-Nilson . Hirsch

(57) **Zusammenfassung**

Bei einem digital gesteuerten Lautstärkenregler erfolgt eine stufenweise Umschaltung zum Erhöhen/Verringern der Dämpfung eines Audiosignals um jeweils z. B. 2dB. Die mit dem jeweiligen Umschaltvorgang einhergehende abrupte Signaländerung wird vermieden durch ein Verstärkungsglied (30) bzw. ein Dämpfungsglied mit einer Verstärkung/Dämpfung, die der abgestuften Dämpfung der Spannungsteileranordnung entspricht. Im Zeitpunkt des Umschaltens der Spannungsteileranordnung (2, 12) wird das Verstärkungsglied/Dämpfungsglied vorübergehend aktiviert, so daß der Umschaltvorgang nicht abrupt, sondern erst allmählich wirksam wird.

## Beschreibung

Die Erfindung betrifft einen Lautstärkenregler für ein Audiogerät, mit einer Spannungsteileranordnung, der eingangsseitig ein Audio-Eingangssignal zugeführt wird, und die am Ausgang ein um einen definierten Pegel gedämpftes Audio-Ausgangssignal abgibt, wobei eine digitale Steuereinrichtung die Verbindung des Ausgangs mit den einzelnen Abgriffen von Stufen der Spannungsteileranordnung einstellt.

Ein solcher Lautstärkenregler ist bekannt. Er wird für Audio-Geräte, speziell für Audioprozessoren eingesetzt und als integrierte Schaltung ausgebildet. Die Spannungsteileranordnung enthält zwei Spannungsteiler mit jeweils mehreren Abgriffen, wobei ein erster Spannungsteiler Dämpfungsstufen von jeweils 2dB, und ein zweiter Spannungsteiler Dämpfungsstufen von jeweils 16dB liefert. Die einzelnen Abgriffe des ersten Spannungsteilers können über einen von der digitalen Steuereinrichtung angesteuerten Analogschalter mit dem Eingang des zweiten Spannungsteilers verbunden werden. Ein ebenfalls von der digitalen Steuereinrichtung gesteuerter Analogschalter verbindet einen der Abgriffe des zweiten Spannungsteilers mit dem Ausgang. Die digitale Steuereinrichtung empfängt Datensignale, die für eine gewünschte Lautstärke bezeichnend sind und stellt entsprechend die beiden Spannungsteiler ein.

Die Umschaltung der Verbindung des Ausgangs mit den jeweiligen Abgriffen der Spannungsteileranordnung erfolgt so, daß schrittweise eine Dämpfungsänderung von 2dB erfolgt. Da sich bei einer Umschaltung die Amplitude des Ausgangssignals abrupt ändert, macht sich der Umschaltvorgang in einem deutlich hörbaren Klicken des reproduzierten Audiosignals unangenehm bemerkbar. Dies gilt für höherfrequente Signale (z. B. 10 kHz) als auch für niederfrequente Signale (z. B. 100 Hz), insbesondere für reine Sinussignale.

Aus der US-A-5 204 908 ist ein Lautstärkenregler der oben genannten Art bekannt, bei dem der als Potentiometer ausgebildeten Spannungsteileranordnung mehrere parallel geschaltete Optokoppler nachgeordnet sind, wobei jeweils ein Optokoppler zu einem an einen Lautsprecher angeschlossenen Kanal gehört, dem eine bestimmte Dämpfung zugeordnet ist. Von der Steuereinrichtung wird jeweils einem der Optokoppler ein Signal zugeführt, um den Kanal zu öffnen. Das Audiosignal durchläuft den geöffneten Kanal entweder ungedämpft oder mit einer entsprechenden, voreingestellten Dämpfung. Bei dem Umschaltvorgang sorgt das Einschalt- und Ausschaltverhalten des jeweiligen Optokopplers für einen allmählichen Signalübergang, so daß das störende "Klicken" im Lautsprecher verhindert wird. In einer alternativen Ausführungsform sind statt der Optokoppler Analogschalter vorgesehen. Um dabei das unerwünschte "Klicken" im Lautsprecher zu vermeiden, ist den Analogschaltern ein RC-Glied nachgeordnet. Dieses RC-Glied bewirkt eine dauernde Pegelverringerung. Die Anzahl der Abstufungen legt die Anzahl der Optokoppler bzw. der RC-Glieder fest. Wenn man eine größere Anzahl von Abstufungen hat, läßt sich die bekannte Schaltung nicht als integrierte Schaltung realisieren.

Der Erfindung liegt die Aufgabe zugrunde, einen Lautstärkenregler der eingangs genannten Art anzugeben, bei dem im Fall einer Lautstärkenverringerung und/oder im Fall einer Lautstärkenerhöhung das durch das Umschalten bedingte Schaltgeräusch weitestgehend vermieden wird.

Gelöst wird diese Aufgabe erfindungsgemäß dadurch, daß dem Lautstärkeregler ein Verstärkungsglied und/oder ein Dämpfungsglied mit einer der Abstufung des Spannungsteilers entsprechenden Verstärkung/Dämpfung zugeordnet ist, welches bei einem Lautstärkenumschaltsignal gleichzeitig mit dem Umschalten der Spannungsteileranordnung durch die digitale Steuerung über einen Analogschalter in Betrieb gesetzt wird, der mit einem Signal angesteuert wird, das nach einem Amplitudensprung allmählich abklingt.

Das insbesondere zwischen den Ausgang der Spannungsteileranordnung und den Lautsprecher/Kopfhörer eingefügte Verstärkungsglied/ Dämpfungsglied verhindert den Signalsprung und sorgt stattdessen für einen allmählichen Übergang des Audiosignals auf den neuen Pegel.

Das Signal zum Aktivieren des Verstärkungsglieds/Dämpfungsglieds kann mit Hilfe eines RC-Glieds gewonnen werden. Erzeugt wird dieses Signal immer dann, wenn die digitale Steuerung, welche die Einstellung der Spannungsteileranordnung steuert, ein Umschaltsignal (abhängig von einem neuen Lautstarkensignal) erzeugt. Im Gegensatz zu der aus der US-A-5 204 908 bekannten Schaltung sind hier lediglich zwei RC-Glieder erforderlich, unabhängig von der Anzähl der Signalabstufungen.

Wenn z. B. eine Lautstärkenverringerung um 2dB erfolgt, wozu die digitale Steuerung den Ausgang der Spannungsteileranordnung mit einem anderen Abgriff der Spannungsteileranordnung verbindet, wird mit dem Umschaltvorgang gleichzeitig ein Aktivierungssignal erzeugt, welches das Verstärkungsglied am Ausgang der Spannungsteileranordnung aktiviert. Dieses Verstärkungsglied bewirkt dann kurzfristig eine Verstärkung um 2dB (die Verstärkung des Verstärkungsglieds ist auf die Abstufung der Spannungsteileranordnung abgestimmt). Wenn dann anschließend das Aktivierungssignal des Verstärkungsglieds abklingt, wird die durch das Verstärkungsglied bewirkte Verstärkung allmählich unwirksam, und dementsprechend wird die Umschaltung der Spannungsteileranordnung auf die um 2dB erhöhte Dämpfung allmählich wirksam. Durch dieses erst allmählich erfolgende Wirksamwerden der Umschaltung der Spannungsteileranordnung gibt es im Ausgangssignal keine abrupte Signaländerung, und dementsprechend gibt es auch kein störendes Klicken bei dem Umschaltvorgang.

Das Verstärkungsglied ist jeweils nur für eine kurze Zeitspanne wirksam, m der übrigen Zeit ist es unwirksam (Verstärkung 0dB). In analoger Weise kann ein Dämpfungsglied vorgesehen werden, das im Ruhezustand eine Dämpfung von 0dB macht. Wenn es bei einer Erhöhung der Lautstärke um 2dB aktiviert wird, bewirkt es zunächst eine Dämpfung um 2dB, wobei diese Dämpfung dann allmählich abnimmt, so daß die Erhöhung der Lautstarke allmählich am Ausgang wirksam wird.

In der bevorzugten Ausführungsform sind an den Ausgang der Spannungsteileranordnung ein Verstärkungsglied und ein Dämpfungsglied angeschlossen. In Spezialfällen kann es ausreichen, wenn nur ein Dämpfungsglied oder ein Verstärkungsglied vorhanden ist. Verstärkungsglied und Dämpfungsglied können auch zusammengefaßt und mit einem gemeinsamen Analogschalter angesteuert werden.

Im folgenden wird ein Ausführungsbeispiel der Erfindung anhand der Zeichnung naher erläutert. Es zeigen:
- Fig. 1: eine schematische Schaltungsskizze eines Lautstärkenreglers gemäß der Erfindung,
- Fig. 2: Wellenformdiagramme zum Veranschaulichen der abrupten Signaländerung bei dem Lautstärkenregler nach dem Stand der Technik,
- Fig. 3: Wellenformdiagramme zum Veranschaulichen der Arbeitsweise des erfindungsgemäßen Lautstärkenreglers bei Verringerung der Lautstärke, und
- Fig. 4: eine Schaltungsskizze einer alternativen Ausführungsform von Verstärkungs- und Dämpfungsglied.

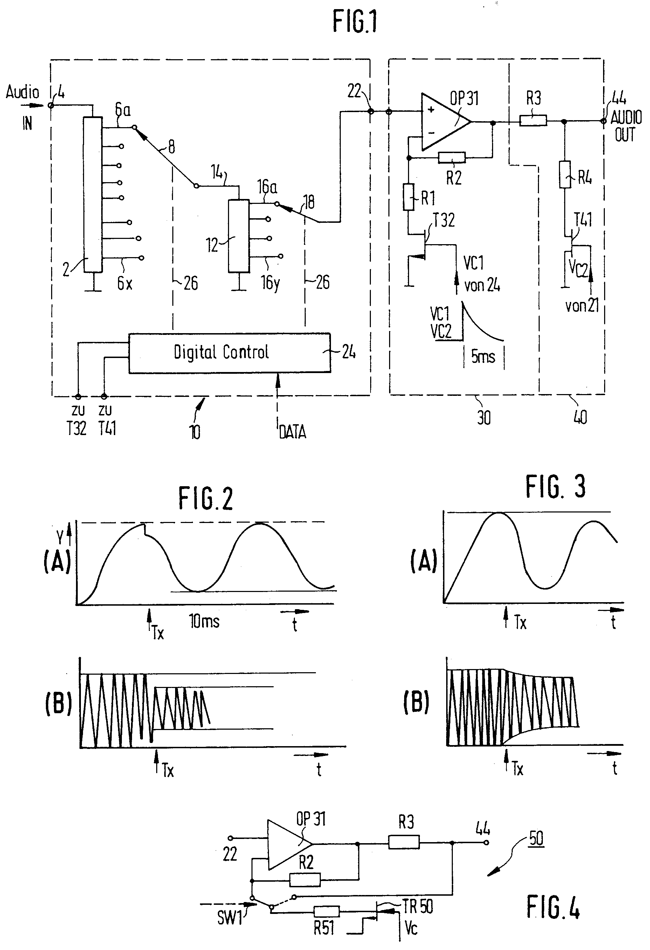

Zunächst soll anhand des linken Teils der Fig. 1 ein zum Stand der Technik gehöriger Lautstärkervegler 10 erläutert werden.

Der Lautstärkerregler 10 enthält zwei Spannungsteiler 2 und 12, von denen der erste Spannungsteiler 2 über einen Audioeingang 4 ein Audiosignal empfängt und an einem seiner Anzapfpunkte 6a .... 6x ein gedämpftes Signal abgibt. Die Abstufung zwischen den einzelnen Abgriffen beträgt jeweils 2dB. Über einen schematisch dargestellten Analogschalter 8 gelangt das von einem der Abgriffe 6a .... 6x abgenommenen Signal an den Eingang 14 des zweiten Spannungsteilers 12. Dieser hat Abgriffe 16a bis 16y mit einer Abstufung von 16dB zwischen zwei aufeinanderfolgenden Abgriffen. Von einem dieser Abgriffe wird das gedämpfte Audiosignal über einen schematisch angedeuteten Analogschalter 18 an den Ausgang 22 des Lautstärkenreglers geführt.

Die Einstellung der Analogschalter 8 und 18 erfolgt nach Maßgabe eines Datensignals (DATA) welches eine gewünschte Lautstärke repräsentiert, durch eine digitale Steuereinrichtung 24 (Digital Control). Die digitale Steuereinrichtung (24) stellt die Analogschalter 8 und 18 über Steuerleitungen 26 ein. Die Umschaltung erfolgt jeweils in Schritten von 2dB.

Fig. 2(A) zeigt den Verlauf einer reinen Sinuswelle mit einer Frequenz von 100 Hz. Im Zeitpunkt Tx erfolgt ein Umschalten auf eine geringere Lautstärke. Die digitale Steuereinrichtung 24 schaltet die Spannungsteileranordnung 2, 12 so um, daß das Eingangssignal am Eingang 4 um (weitere) 2dB gedämpft wird. Diese Dämpfung bewirkt eine abrupte Signalpegelverminderung, was in Fig. 2(A) an der Stelle Tx angedeutet ist.

Fig. 2(B) zeigt den gleichen Vorgang für ein höherfrequentes Signal mit einer Frequenz von 10 kHz.

In beiden Fällen macht sich die abrupte Signaländerung als unangenehmes Klicken im Lautsprecher bemerkbar.

Erfindungsgemäß ist an den Ausgang 22 des Lautstärkenreglers ein Verstärkungsglied 30 angeschlossen, welches aus der oben erläuterten abrupten Signaländerung im Zeitpunkt Tx eine allmähliche Signaländerung macht und dadurch das unangenehme Klicken im Umschaltzeitpunkt verhindert.

Das Verstärkungsglied 30 enthält einen Operationsverstärker OP31, dessen nicht-invertierendem Eingang das Ausgangssignal von der Spannungsteileranordnung 2, 12 über den Ausgang 22 zugeführt wird. Der invertierende Eingang des Operationsverstärkers OP liegt über einen Widerstand R1 und einen MOSFET (MOS-Feldeffekttransistor) TR 32 auf Masse. Der Knoten zwischen dem Widerstand R1 und dem invertierenden Eingang des Operationsverstärkers OP31 ist über einen Widerstand R2 mit dem Ausgang des Operationsverstärkers OP31 verbunden.

Dem Verstärkungsglied 30 nachgeordnet ist ein Dämpfungsglied 40 mit einem am Ausgang des Operationsverstärkers OP31 liegenden Widerstand R3, dessen anderer Anschluß den Audioausgang 44 bildet. Mit dem Audioausgang 44 ist ein Widerstand R4 verbunden, der über einen weiteren MOSFET T41 auf Masse geschaltet ist.

Die beiden Transistoren T32 des Verstärkungsglieds 30 und T41 des Dämpfungsglieds 40 empfangen von der digitalen Steuerung 24 jeweils ein Steuersignal VC1 bzw. VC2, die identischen Verlauf haben können, wie unten in dem das Verstärkungsglied 30 andeutenden Kästchen dargestellt ist.

Im folgenden soll der Fall beschrieben werden, daß der Lautstärkenregler 10 von der digitalen Steuerung 24 so umgeschaltet wird, daß die Lautstärke verringert wird. Der Umschaltvorgang beim Erhöhen der Lautstärke geschieht in ähnlicher Weise, nur mit dem Unterschied, daß nicht das Verstärkungsglied 30 aktiviert wird, sondern das Dämpfungsglied 40.

Das Gate des MOSFETs T32 empfängt bei dem oben erläuterten Umschaltvorgang der Spannungsteileranordnung ein Steuersignal VC1, welches gekennzeichnet ist durch einen abrupten Signalanstieg mit anschließender abfallender Signalamplitude. Die Abfallzeit der Signalamplitude beträgt etwa 5 ms im vorliegenden Ausführungsbeispiel.

Wenn das Umschalten der Spannungsteileranordnung 2, 12 durch die digitale Steuereinrichtung 24 erfolgt, wird auch das Signal Vc1 erzeugt, beispielsweise wird dieses Signal Vc1 ebenfalls von der digitalen Steuerung 24 über ein darin ausgebildetes RC-Glied erzeugt. Das Signal VC1 am Gate des MOSFETs T32 öffnet den Transistor zunächst vollständig, so daß das Verstärkungsglied 30 eine Verstärkung von 2dB liefert. Diese Verstärkung macht zunächst die Umschaltung der Spannungsteileranordnung auf eine um 2dB erhöhte Dämpfung unwirksam.

Dadurch, daß das Signal Vc allmählich abklingt, wird der Transistor T32 allmählich wieder hochohinig (sperrend). Nach Abklingen des Signals Vc1 ist das Verstärkungsglied 30 wieder deaktiviert, d. h., es macht eine Verstärkung von 0dB. Damit wird erreicht, daß die Dämpfung der Spannungsteileranordnung nicht sofort, sondern erst allmählich wirksam wird, im vorliegenden Beispiel erst nach einem Übergang von 5 ms. Dieser allmähliche Übergang, der in Fig. 3 in dem an den Zeitpunkt Tx anschließenden Bereichen angedeutet ist, verhindert das störende Klicken durch das Umschalten der Spannungsteileranordnung.

Dem Verstärkungsglied 30 ist ein entsprechend ausgebildetes Dämpfungsglied 40 nachgeschaltet, so daß im Fall einer Lautstärkenerhöhung dieses Dämpfungsglied 40 durch ein ähnliches Signal VC2 wie das Signal Vc1 vorübergehend aktiviert wird, um bei einer Lautstärkenerhöhung ebenfalls ein störendes Klicken im Umschaltzeitpunkt der Spannungsteileranordnung zu vermeiden.

Figur 4 zeigt eine abgewandelte Ausführungsform, bei der das Dämpfungsglied und das Verstärkungsglied zusammengefaßt sind. Der Widerstand R1 des Verstärkungsglieds 30 und der Widerstand R4 des Dämpfungsglieds 40 nach Figur 1 sind ersetzt durch einen gemeinsam verwendeten Widerstand R51, der an einen gemeinsam verwendeten MOSFET T50 angeschlossen ist, dessen Gate ein Steuersignal VC zugeführt wird. Abhängig davon, ob die Lautstärke erhöht oder verringert wird, wird ein Schalter SW1 so umgeschaltet, daß eine vorübergehende Dämpfung bzw. Verstärkung des Signals erfolgt. Das Umschaltsignal für den Schalter SW1 wird zweckmäßigerweise ebenfalls von der digitalen Steuerung 24 geliefert.

## Patentansprüche

1. Lautstärkenregler für ein Audiogerät, mit einer Spannungsteileranordnung (2, 12), der eingangsseitig ein Audio-Eingangssignal zugeführt wird, und die am Ausgang (22) ein um einen definierten Pegel gedämpftes Audio-Ausgangssignal abgibt, wobei eine digitale Steuereinrichtung (24, 26) die Verbindung des Ausgangs (22) mit den einzelnen Abgriffen (6a - 6x; 16a - 16y) von Stufen der Spannungsteileranordnung (2, 12) einstellt,
dadurch gekennzeichnet, daß dem Lautstärkenregler ein Verstärkungsglied (30) und/oder ein Dämpfungsglied (40) mit einer der Abstufung des Spannungsteilers (2, 12) entsprechender Vestärkung/Dämpfung zugeordnet ist, welches bei einem Lautstärkenumschaltsignal gleichzeitig mit dem Umschalten der Spannungsteileranordnung (2, 12) durch die digitale Steuerung (24, 26) über einen Analogschalter (T32, T41) in Betrieb gesetzt wird, der mit einem Signal angesteuert wird, das nach einem Amplitudensprung allmählich abklingt.

2. Lautstärkenregler nach Anspruch 1,
dadurch gekennzeichnet, daß die Spannungsteileranordnung (2,12) derart ausgebildet ist, daß sie bei einem Umschaltvorgang eine Verringerung oder Erhöhung der Dämpfung um jeweils bspw. 2dB bewirkt, und daß das Verstärkungsglied/Dämpfungsglied für eine vorübergehende Verstärkung/Dämpfung um bspw. 2db ausgelegt ist.

3. Lautstärkenregler nach Anspruch 1 oder 2,
dadurch gekennzeichnet, daß das Verstärkungsglied/Dämpfungsglied (30, 40) an den Ausgang (22) des Lautstärkenreglers (10) angeschlossen ist.

4. Lautstärkenregler nach einem der Ansprüche 1 bis 3,
dadurch gekennzeichnet, daß ein Verstärkungs-Dämpfungsglied (50) vorgesehen ist, das abhängig von der Richtung der Pegeländerung durch den Lautstärkenregler (10) zwischen Verstärkung und Dämpfung umgeschaltet wird und einen gemeinsamen Analogschalter (T50) für die In-Betrieb-Setzung aufweist.
